# EUROPEAN PATENT APPLICATION

(11) **EP 4 223 663 A1**
(43) Date of publication of application: **09.08.2023**
(21) Application number: 21875550.2
(22) Date of filing: 27.09.2021
(51) Int. Cl.: B65D 65/40

(54) **PACKAGING MATERIAL, PACKAGING BAG, AND PACKAGE**

(30) Priority: 29.09.2020 JP 2020163611
(71) Applicant: TOPPAN INC., Tokyo 110-0016 (JP)
(72) Inventor: TANAKA, Ryota, Tokyo 110-0016 (JP); OCHIAI, Shinya, Tokyo 110-0016 (JP); WATANABE, Kotaro, Tokyo 110-0016 (JP); OKEYA, Yuta, Tokyo 110-0016 (JP)
(74) Representative: Hoffmann Eitle
(86) International application number: PCT/JP2021/035450
(87) International publication number: WO 2022/071248

(57) **Abstract**

A packaging material for packaging contents containing fragrances includes a first polyolefin layer, an inorganic deposition layer, a gas barrier coating layer, and a second polyolefin layer having heat-sealing properties, in this order.

## Description

### [Technical Field]

The present disclosure relates to packaging materials, packaging bags, and packaging bodies. Specifically, the present disclosure relates to packaging materials for packaging contents containing fragrances, that is, recyclable packaging materials capable of suppressing dissipation of fragrance materials and fragrance transfer. Also, the present disclosure relates to packaging bags which use the recyclable packaging materials, and packaging bodies.

### [Background Art]

In recent years, it has become a mainstream tendency to sell hair care products such as shampoos and conditioners, liquid laundry detergents, fabric softeners, etc. by filling them in flexible packaging materials in order to reduce the amount of plastic used, and to transfer them to plastic bottles for home use.

These packaging materials (flexible packaging materials) are produced by laminating plastic films and forming the laminates into bags. As an example of the production method, a printed layer is formed on a polyethylene terephthalate (PET) film having a thickness of 12 µm using gravure printing, and a nylon film (Ny) having a thickness of 15 µm is bonded to the printed surface using a dry lamination method via a urethane adhesive to obtain a laminate. The nylon film surface of the laminate is similarly bonded to a linear low density polyethylene (LLDPE) having a thickness of 100 µm to obtain a laminate with a PET/Ny/LLDPE structure. Next, the LLDPE surfaces of this laminate are located face to face and heat-sealed for formation into a bag to obtain a packaging bag. In consideration of display suitability at stores and ease of pouring, a standing pouch with a spout is generally used for the shape of such packaging bags.

Laminates with a PET/LLDPE structure or Ny/LLDPE structure are similarly used. These laminates are obtained by forming a printed layer on a nylon film (Ny) having a thickness of 15 µm or on a polyethylene terephthalate (PET) film having a thickness of 12 µm using a gravure printing method, and bonding the printed surface to a linear low density polyethylene (LLDPE) having a thickness of 120 µm via a urethane adhesive using a dry lamination method.

There has been proposed a flexible packaging material mainly made of polyolefins, in place of flexible packaging bags, obtained by combining such different resins with each other (e.g., see PTL 1). This is because, from the perspective of waste problems including marine pollution due to plastics, the need to use recyclable flexible packaging materials has been increasing in recent years for the purpose of reducing the amount of plastic used.

### [Citation List]

### [Patent Literatures]

PTL 1: WO 2019/189092

### [Summary of the Invention]

### [Technical Problem]

However, filling flexible packaging materials mainly made of polyolefins such as polyethylenes and polypropylenes with contents containing fragrances and sealing the packaging materials raises issues of dissipation of fragrance components and associated transfer of fragrance to other articles, compared to filling contents in packaging bags formed of laminates with a PET/Ny/LLDPE structure or a Ny/LLDPE structure.

The present disclosure has been made in light of the circumstances described above and aims to provide a packaging material which can achieve good permeation-inhibiting properties for fragrance components, using polyolefins as main materials. The present disclosure also aims to provide a packaging bag using the packaging material, and a packaging body.

### [Solution to Problem]

The present inventors have investigated polyolefin packaging materials that can be recycled and are resistant to dissipation of fragrance components or fragrance transfer. As a result, the inventors have found that a packaging material in which a first polyolefin layer, an inorganic deposition layer, a gas barrier coating layer, and a second polyolefin layer with heat-sealing properties are laminated can achieve the above aims, and have completed the packaging material of the present disclosure.

Specifically, a packaging material according to an aspect of the present disclosure is a packaging material for packaging contents containing fragrances, including a first polyolefin layer, an inorganic deposition layer, a gas barrier coating layer, and a second polyolefin layer having heat-sealing properties, in this order.

The glass-transition temperature (Tg) of PET is around 70°C and that of Ny is around 50°C. If these materials are used for films forming a packaging bag, molecules in the amorphous part of PET or Ny under normal operating conditions are in a glass state in which thermal motion is moderate, and therefore, the fragrance components are less likely to dissolve into these films, inhibiting permeation. Thus, if a packaging bag formed of a laminate with a PET/Ny/LLDPE or Ny/LLDPE structure is used, fragrance components are less likely to dissipate and the fragrance is less likely to be transferred to other articles. In contrast, the glass-transition temperature of polyethylenes is around -125°C and that of polypropylenes is around 0°C. If these materials are used for films forming a packaging bag, molecular chains in the amorphous part of the polyethylenes or polypropylenes at normal operating temperature are in a state in which thermal motion is active, and therefore, the fragrance components are likely to dissolve into these films and permeate through the packaging bag. In flexible packaging materials mainly formed of a polyolefin such as polyethylene and polypropylene, it is important to have a layer structure as in the present invention, from the perspective of inhibiting permeation of fragrance components. This specifically means that, by devising the layer structure, polyolefin packaging materials can achieve fragrance permeation-inhibiting properties equivalent to those of polyester packaging materials.

In an aspect, the gas barrier coating layer may be a heat-dried product of a composition containing at least one of a hydroxyl group-containing polymer compound and a hydrolysate thereof, and at least one material selected from the group consisting of metal alkoxides, silane coupling agents, and hydrolysates thereof.

In an aspect, the gas barrier coating layer may contain a polycarboxylic acid polymer crosslinked with polyvalent metal or a polyvalent metal compound.

In an aspect, the gas barrier coating layer may be a cured product of an adhesive composition containing a resin having at least either of aromatic rings and aliphatic rings.

In an aspect, the inorganic deposition layer may contain at least one of aluminum oxide and silicon oxide.

In an aspect, the first polyolefin layer and the second polyolefin layer may be made of the same material.

In an aspect, the first polyolefin layer and the second polyolefin layer may be made of polyethylenes.

In an aspect, the first polyolefin layer and the second polyolefin layer may be made of polypropylenes.

A packaging bag according to an aspect of the present disclosure is formed of the above packaging material.

A packaging body according to an aspect of the present disclosure includes the above packaging bag and contents containing fragrances packaged in the packaging bag.

In an aspect, the fragrance materials may contain at least either of esters and terpenes.

### [Advantageous Effects of the Invention]

According to the present disclosure, there is provided a packaging material which can achieve good permeation-inhibiting properties for fragrance components, using polyolefins as main materials. Furthermore, according to the present disclosure, there are provided a packaging bag using the packaging material, and a packaging body.

### [Brief Description of the Drawings]

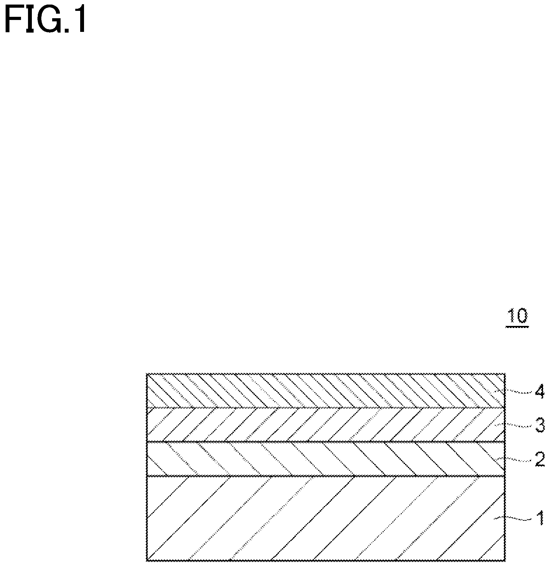

Fig. 1 is a cross-sectional view illustrating a mode of a packaging material according to the present disclosure.

### [Description of the Embodiments]

Preferred embodiments of the present disclosure will now be described in detail with occasional reference to the drawings. In the drawings, like components are given like reference signs to omit duplicate description. Also, dimensional ratios in the drawings should not be limited to the ratios shown in the drawings.

### <Packaging material>

The packaging material of the present disclosure is used for packaging contents containing fragrances. Such fragrance materials may include esters such as isobutyl formate, ethyl acetate, methyl butyrate, ethyl butyrate, ethyl hexanoate, ethyl methyl butyrate, ethyl 2-methyl butyrate, ethyl 2-methyl valeric acid, hexyl acetate, allyl hexanoate, allyl heptanoate, benzyl acetate, amyl butyrate, amyl valeric acid, isoamyl acetate, α-methylbenzyl acetate, β-pinene, allyl cyclohexane propionate, 2-phenoxyethyl isobutyrate, and methyl salicylate; and terpenes such as limonene, citronellol, linalool, nerol, nerolidol, α-terpineol, myrcene, thymol, and thioterpineol. These contents containing fragrances may include hair care products such as shampoos and conditioners, liquid laundry detergents, and fabric softeners. The packaging material of the present disclosure has good permeation-inhibiting properties for esters and terpenes in particular. Esters and terpenes both have common characteristics that solubility parameters (SP values) are close to those of polyolefins.

Solubility parameters (SP values) are values defined based on the regular solution theory, and it is empirically known that the smaller the difference in SP values between two components, the greater the solubility. The SP value of polyethylenes is 8.6 (cal/cm³)^{1/2}, while that of polypropylenes is 8.0 (cal/cm³)^{1/2}. On the other hand, the SP value of esters is around 7.8-8.5 (cal/cm³)^{1/2} and that of terpenes such as limonene is around 7.3-7.8 (cal/cm³)^{1/2}, of which the differences from the SP value of polyethylenes or polypropylenes are small. It should be noted that the SP value of PET is 13.3 (cal/cm³)^{1/2} and that of Ny is 9.9-13.7 (cal/cm³)^{1/2}, of which the differences from the SP value of esters or terpenes are greater compared to the SP value of polyolefins, indicating that the solubility is small. As described above, fragrance permeation-inhibiting properties in conventional packaging can be explained from the perspective of SP values.

The packaging material of the present disclosure includes a first polyolefin layer, an inorganic deposition layer, a gas barrier coating layer, and a second polyolefin layer having heat-sealing properties, in this order.

Fig. 1 is a cross-sectional view illustrating a mode of the packaging material according to the present disclosure. A packaging material 10 includes a first polyolefin layer 1, an inorganic deposition layer 2, a gas barrier coating layer 3, and a second polyolefin layer 4 having heat-sealing properties, in this order. In the figure, the inorganic deposition layer 2 is formed on one surface of the first polyolefin layer 1; however, inorganic deposition layers may be formed on both surfaces of the first polyolefin layer 1. The second polyolefin layer 4 may be laminated on the gas barrier coating layer 3 via an adhesive layer (not shown).

### (First polyolefin layer)

The first polyolefin layer serves as a substrate (polyolefin film) on which an inorganic deposition layer is formed. Polyolefins for forming the first polyolefin layer include polyethylenes and polypropylenes.

The polyethylenes may be high-density polyethylenes (HDPEs), considering deposition processing, printing processing, bag-forming processing, suitability for filling, and the like. In order to enhance physical properties such as flexibility, a multilayer film with a structure of high-density polyethylene (HDPE) / medium-density polyethylene (MDPE) / low-density polyethylene (LDPE) / medium-density polyethylene (MDPE) / high-density polyethylene (HDPE), for example, formed using a coextrusion method may be used as the first polyolefin layer.

The polypropylenes may be stretched polypropylenes. In general, polypropylenes are categorized into homopolymers, random copolymers, block copolymers, and terpolymers, and the polymer type is selected from these types, according to usage or required performance; however, when used as substrate films of packaging materials, homopolymer polypropylenes are preferred. For the purpose of imparting adhesion-enhancing properties or sealing properties, a multilayer film in which a copolymer or terpolymer is formed as a skin layer using a coextrusion method may be used as the first polyolefin layer.

The polyolefins forming the first polyolefin layer may be recycled polyolefins, or may be polyolefins obtained by polymerizing raw materials derived from biomass such as of plants. These polyolefins may be used singly or may be mixed with polyolefins polymerized from ordinary fossil fuels.

The polyolefin film forming the first polyolefin layer may be a stretched or non-stretched film. However, from the perspective of impact resistance, heat resistance, water resistance, dimensional stability, and the like, the polyolefin film may be a stretched film. Thus, the laminate can be more preferably used for applications for hot filling. The stretching method is not particularly limited, but the film may be stretched using any method, such as inflation, uniaxial stretching, or biaxial stretching, as long as a dimensionally stable film can be supplied.

The thickness of the polyolefin film is not particularly limited. The thickness may be 6 µm to 200 µm according to applications, but is more preferred to be 9 µm to 50 µm, and even more preferred to be 12 µm to 38 µm, from the perspective of obtaining good impact resistance and good gas barrier properties.

In order to enhance adhesion to the inorganic deposition layer, the first polyolefin layer may undergo various pretreatments such as corona treatment, plasma treatment, and flame treatment as long as the barrier performance is not impaired.

### (Adhesive layer)

The surface of the first polyolefin layer on which the deposition layer is laminated may be provided with an adhesive layer (anchor coat layer). The adhesive layer can impart two effects, which are improvement of adhesion performance between the first polyolefin layer and the inorganic deposition layer, and improvement of smoothness of the polyolefin layer surface. With the smoothness improved, the inorganic deposition film can be uniformly formed with ease without defects, and high barrier properties can be easily developed.

The thickness of the adhesive layer is not particularly limited but is preferred to be in the range of 0.01 µm to 5 µm, more preferred to be in the range of 0.03 µm to 3 µm, and even more preferred to be in the range of 0.05 µm to 2 µm. If the thickness of the adhesive layer is not less than the lower limit, more sufficient interlayer adhesion strength is likely to be obtained, and if it is not more than the upper limit, desired gas barrier properties are likely to be developed.

The adhesive layer can be formed using an anchor coating agent. Examples of the anchor coating agent include polyester polyurethane resins, polyether polyurethane resins, and acrylic polyurethane resins Of these materials, polyester polyurethane resins are preferred from the perspective of heat resistance and interlayer adhesion strength.

As a method of forming an adhesive layer on the first polyolefin layer, any known coating method can be used without particular limitation, including an immersion method (dipping method), and methods using sprayers, coaters, printers, brushes, and the like. Also, types of coaters and printers used in these methods and their coating methods may include gravure coaters, reverse roll coaters, micro gravure coaters, coaters combined with chamber doctor, air knife coaters, dip coaters, bar coaters, comma coaters, and die coaters used for a direct gravure method, reverse gravure method, kiss reverse gravure method, offset gravure method, and the like.

As the amount of the adhesive layer applied, the mass per square meter after coating and drying the anchor coating agent is preferred to be 0.01 to 5 g/m², and is more preferred to be 0.03 to 3 g/m². If the mass per square meter after coating and drying the anchor coating agent is not less than the lower limit, film formation is likely to be sufficient, and if it is not more than the upper limit, the layer is likely to be sufficiently dried and the solvent is less likely to remain.

The drying method may include, but are not particularly limited to, a natural drying method, a method using an oven which is set to a predetermined temperature, and a method using a drying machine, such as an arch dryer, floating dryer, drum dryer, or infrared dryer, attached to the above coaters. Drying conditions can be appropriately selected according to the drying method. For example, if an oven is used, the layer is preferred to be dried at a temperature of 60 to 100°C for about 1 second to 2 minutes.

As the anchor coating agent, a polyvinyl alcohol resin may be used. The polyvinyl alcohol resin may be a resin having vinyl alcohol units obtained by saponifying vinyl ester units, including, for example, polyvinyl alcohols (PVA) and ethylene-vinyl alcohol copolymers (EVOH).

The PVA may be, for example, a resin obtained by polymerizing a vinyl ester alone, such as vinyl acetate, vinyl formate, vinyl propionate, vinyl valerate, vinyl caprate, vinyl laurate, vinyl stearate, vinyl pivalate, or vinyl versatate, followed by saponification. The PVA may be a modified PVA obtained by copolymerization modification or post-modification. The modified PVA can be obtained by, for example, copolymerizing vinyl ester and an unsaturated monomer copolymerizable with the vinyl ester, followed by saponification. Examples of the unsaturated monomer copolymerizable with vinyl ester include: olefins such as ethylene, propylene, isobutylene, α-octene, α-dodecene, and α-octadecene; hydroxy group-containing α-olefins such as 3-buten-1-ol, 4-pentyn-1-ol, and 5-hexen-1-ol; unsaturated acids such as acrylic acid, methacrylic acid, crotonic acid, maleic acid, maleic anhydride, itaconic acid, and undecylenic acid; nitriles such as acrylonitrile and methacrylonitrile; amides such as diacetone acrylamide, acrylamide, and methacrylamide; olefin sulfonic acids such as ethylene sulfonic acid, allyl sulfonic acid, and methallyl sulfonic acid; vinyl compounds such as alkyl vinyl ether, dimethyl allyl vinyl ketone, N-vinylpyrrolidone, vinyl chloride, vinyl ethylene carbonate, 2,2-dialkyl-4-vinyl-1,3-dioxolane, glycerin monoallyl ether, and 3,4-diacetoxy-1-butene; vinylidene chloride; 1,4-diacetoxy-2-butene; and vinylene carbonate.

The PVA is preferred to have a polymerization degree of 300 to 3,000. If the polymerization degree is lower than 300, barrier properties are likely to decrease, and if it exceeds 3,000, coating suitability is likely to decrease due to the viscosity being excessively high. The PVA is preferred to have a saponification degree of 90 mol% or more, more preferably 95 mol% or more, and even more preferably 99 mol% or more. The saponification degree of the PVA may be 100 mol% or less, or may be 99.9 mol% or less. The polymerization degree and the saponification degree of the PVA can be measured according to the method described in JIS K 6726 (1994).

In general, EVOH is obtained by saponifying copolymers of ethylene and acid vinyl ester such as vinyl acetate, vinyl formate, vinyl propionate, vinyl valerate, vinyl caprate, vinyl laurate, vinyl stearate, vinyl pivalate, and vinyl versatate.

The EVOH is preferred to have a polymerization degree of 300 to 3,000. If the polymerization degree is lower than 300, barrier properties are likely to decrease, and if it exceeds 3,000, coating suitability is likely to decrease due to the viscosity being excessively high. The vinyl ester component of the EVOH is preferred to have a saponification degree of 90 mol% or more, more preferably 95 mol% or more, and even more preferably 99 mol% or more. The saponification degree of the EVOH may be 100 mol% or less, or may be 99.9 mol% or less. The saponification degree of the EVOH is determined from the peak area of hydrogen atoms in the vinyl ester structure and the peak area of hydrogen atoms in the vinyl alcohol structure by performing nuclear magnetic resonance (1H-NMR) measurement.

The ethylene unit content in the EVOH is preferred to be 10 mol% or more, more preferred to be 15 mol% or more, even more preferred to be 20 mol% or more, and most preferred to be 25 mol% or more. Furthermore, the ethylene unit content in the EVOH is preferred to be 65 mol% or less, more preferred to be 55 mol% or less, and even more preferred to be 50 mol% or less. If the ethylene unit content is 10 mol% or more, good gas barrier properties or dimensional stability can be maintained under high humidity. If the ethylene unit content is 65 mol% or less, gas barrier properties can be enhanced. The ethylene unit content in the EVOH can be calculated using an NMR method.

If a polyvinyl alcohol resin is used as an adhesive layer, the method of forming the adhesive layer may be coating using a polyvinyl alcohol resin solution, multilayer extrusion, or other methods. If multilayer extrusion is used, the layers may be laminated via an adhesive resin such as a maleic anhydride graft modified polyethylene.

From the perspective of improving adhesion between the substrate layer and the deposition layer, the anchor coating agent may contain a silane coupling agent. Silane coupling agents containing any organic functional group may be used, including, for example, silane coupling agents such as vinyl trimethoxysilane, γ-chloropropyl methyldimethoxysilane, γ-chloropropyl trimethoxysilane, glycidoxypropyl trimethoxysilane, γ-methacryloxypropyl trimethoxysilane, and γ-methacryloxypropyl methyldimethoxysilane, and hydrolysates thereof. These materials may be used singly or in combination of two or more.

Of these silane coupling agents, agents having functional groups reacting with the hydroxyl groups of polyols or the isocyanate groups of isocyanate compounds are preferred. Examples thereof include those which contain isocyanate groups, such as γ-isocyanatepropyltriethoxysilane and γ-isocyanatepropyltrimethoxysilane, those which contain mercapto groups, such as γ-mercaptopropyltriethoxysilane, and those which contain amino groups, such as γ-aminopropyltriethoxysilane, γ-aminopropyltrimethoxysilane, N-β-(aminoethyl)-γ-aminopropyltriethoxysilane, and γ-phenylaminopropyltrimethoxysilane. Furthermore, such silane coupling agents may include those which contain epoxy groups, such as γ-glycidyloxypropyltrimethoxysilane and β-(3,4-epoxycyclohexyl)ethyltrimethoxysilane, and those which are obtained by adding alcohol or the like and hydroxyl groups or the like to silane coupling agents, such as vinyltrimethoxysilane, and vinyl-tris(β-methoxyethoxy)silane. These materials may be used singly or in combination of two or more.

The amount of the silane coupling agent may be 0.1 to 100 parts by mass, or more preferably 1 to 50 parts by mass, with respect to 100 parts by mass of the resin (main resin) forming the adhesive layer.

### (Inorganic deposition layer)

The inorganic deposition layer is provided to prevent dissolution of the fragrance components of the contents in the packaging body into the first polyolefin layer. Examples of the material forming the inorganic deposition layer include inorganic oxides such as aluminum oxide, silicon oxide, magnesium oxide, and tin oxide. Accordingly, the inorganic deposition layer may also be referred to as an inorganic oxide layer. From the perspective of transparency and barrier properties, the inorganic oxide may be selected from the group consisting of aluminum oxide, silicon oxide, and magnesium oxide. Also, considering printing suitability and cost, the inorganic oxide may be selected from aluminum oxide and silicon oxide. Furthermore, the inorganic oxide may be made of silicon oxide from the perspective of exhibiting high tensile stretchability during processing. Using an inorganic deposition layer, high barrier properties can be achieved with a considerably thin layer unless the thin layer does not affect recyclability of the gas barrier laminate.

If aluminum oxide is selected as the inorganic deposition layer, the O/Al ratio is preferred to be 1.4 or more. If the O/Al ratio is 1.4 or more, the content of Al metal can be suppressed and high transparency can be easily obtained. The O/Al ratio is preferred to be 1.7 or less. If the O/Al ratio is 1.7 or less, the inorganic deposition layer is prevented from becoming excessively rigid which would be caused by the increase in crystallinity of AlO, and therefore good tensile resistance can be achieved. After the laminate being formed into a bag, the first polyolefin layer may shrink due to heat during hot filling; however, with the O/Al ratio being 1.7 or less, the inorganic deposition layer can easily follow the shrinkage to suppress deterioration in barrier properties. From the perspective of sufficiently achieving these effects, the O/Al ratio of the inorganic deposition layer is preferred to be 1.4 or more and 1.7 or less, and is more preferred to be 1.5 or more and 1.55 or less.

If silicon oxide is selected as the inorganic deposition layer, the O/Si ratio is preferred to be 1.7 or more. If the O/Si ratio is 1.7 or more, the content of Si metal can be suppressed and high transparency can be easily obtained. The O/Si ratio is preferred to be 2.0 or less. If the O/Si ratio is 2.0 or less, the inorganic deposition layer is prevented from becoming excessively rigid which would be caused by the increase in crystallinity of SiO, and therefore good tensile resistance can be achieved. After the laminate is formed into a bag, the first polyolefin layer may shrink due to hot filling or the like; however, with the O/Si ratio being 2.0 or less, the inorganic deposition layer can easily follow the shrinkage to suppress deterioration in barrier properties. From the perspective of sufficiently achieving these effects, the O/Si ratio of the inorganic deposition layer is preferred to be 1.75 or more and 1.9 or less, and is more preferred to be 1.8 or more and 1.85 or less.

The O/Al ratio or the O/Si ratio of the inorganic deposition layer can be calculated using X-ray photoelectron spectroscopy (XPS). For example, an X-ray photoelectron spectroscopy analyzer (JPS-90MXV manufactured by JEOL Ltd.) can be used as a measuring device, and non-monochromatic MgKα (1253.6 eV) can be used as an X-ray source to measure the ratio with an X-ray output of 100 W (10 kV-10 mA).

If aluminum oxide is selected as the inorganic deposition layer, the thickness is preferred to be 5 nm or more and 30 nm or less. If the thickness is 5 nm or more, sufficient gas barrier properties can be easily achieved. If the thickness is 30 nm or less, the occurrence of cracking can be suppressed which would occur due to deformation caused by the internal stress of the layer, and thus deterioration in gas barrier properties can be easily suppressed. It should be noted that, if the thickness exceeds 30 nm, the cost may tend to increase due to increase in the amount of the material used, increase of the time required for layer formation, and the like, and this is not preferable from an economic perspective. From a similar perspective, the thickness of the inorganic deposition layer is more preferred to be 7 nm or more and 15 nm or less.

If silicon oxide is selected as the inorganic deposition layer, the thickness is preferred to be 10 nm or more and 50 nm or less. If the thickness is 10 nm or more, sufficient gas barrier properties can be achieved. If the thickness is 50 nm or less, the occurrence of cracking can be suppressed which would occur due to deformation caused by the internal stress of the layer, and thus deterioration in gas barrier properties can be easily suppressed. It should be noted that, if the thickness exceeds 50 nm, the cost may tend to increase due to increase in the amount of the material used, increase of the time required for layer formation, and the like, and this is not preferable from an economic perspective. From a similar perspective, the thickness of the inorganic deposition layer is more preferred to be 20 nm or more and 40 nm or less.

The inorganic deposition layer can be formed by vacuum deposition, for example. In the vacuum deposition, a physical vapor deposition method or a chemical vapor deposition method can be used. The physical vapor deposition method may include, but is not limited to, a vacuum vapor deposition method, sputtering method, and ion plating method. The chemical vapor deposition method may include, but is not limited to, a thermal CVD method, plasma CVD method, and optical CVD method.

In the vacuum deposition, resistance heating vacuum vapor deposition, electron beam (EB) heating vacuum vapor deposition, induction heating vacuum vapor deposition, sputtering, reactive sputtering, dual magnetron sputtering, plasma-enhanced chemical vapor deposition (PECVD), and the like are particularly preferably used. However, considering productivity, vacuum vapor deposition is most preferable currently. As a heating means for the vacuum vapor deposition, any one of electron beam heating, resistive heating, and inductive heating is preferred to be used.

### (Gas barrier coating layer)

The gas barrier coating layer is formed for the purposes of preventing dissolution of the fragrance components of the contents of the packaging body into the first polyolefin layer, improving gas barrier properties, and protecting the inorganic deposition layer. If minor cracking or the like occurs in the inorganic deposition layer, gas barrier materials can permeate into the cracks to suppress deterioration in gas barrier properties. In contrast to the anchor coat layer, the gas barrier coating layer can be referred to as an overcoat layer.

### (First mode of gas barrier coating layer)

The gas barrier coating layer can contain a hydroxyl group-containing polymer compound, although it is not particularly limited thereto. Specifically, the gas barrier coating layer may be a heat-dried product of a composition containing at least one of a hydroxyl group-containing polymer compound and a hydrolysate thereof, and at least one material selected from the group consisting of metal alkoxides, silane coupling agents, and hydrolysates thereof.

The gas barrier coating layer is formed using a composition which is obtained by adding a hydroxyl-group containing polymer compound and a metal alkoxide and/or a silane coupling agent to water or a water-alcohol mixture (also termed overcoating agent hereinafter). The overcoating agent can be prepared, for example, by mixing a solution in which a hydroxyl group-containing polymer compound is dissolved, as a water-soluble polymer, in an aqueous (water or water-alcohol mixture) solvent, directly with a metal alkoxide and/or a silane coupling agent, or by mixing the solution with these metal alkoxide and/or silane coupling agents that have undergone treatment such as hydrolysis in advance.

The overcoating agent may contain at least a silane coupling agent or a hydrolysate thereof from the perspective of more sufficiently maintaining gas barrier properties after hot-water treatment such as hot filling. Specifically, the overcoating agent may contain at least one of a hydroxyl-group containing polymer compound and a hydrolysate thereof, and at least one of a silane coupling agent and a hydrolysate thereof, or may contain at least one of a hydroxyl-group containing polymer compound and a hydrolysate thereof, at least one of a metal alkoxide and a hydrolysate thereof, and at least one of a silane coupling agent and a hydrolysate thereof.

The hydroxyl-group containing polymer compound may be a polyvinyl alcohol, ethylene-vinyl alcohol copolymer, polyvinylpyrrolidone, starch, methyl cellulose, carboxy methyl cellulose, sodium alginate, or the like. Of these materials, a polyvinyl alcohol (PVA) is preferred to be used as the overcoating agent for the gas barrier coating layer because of having good gas barrier properties.

The metal alkoxide may be a compound expressed by the following General Formula (I).

M(OR¹)m(R²)n-m ... (I)

In General Formula (I), R¹ and R² are each preferred to be independently a monovalent organic group having 1 to 8 carbon atoms, and thus are preferred to be an alkyl group such as a methyl group or ethyl group. M represents an n-valent metal atom such as Si, Ti, Al or Zr. Furthermore, m represents an integer from 1 to n. If there are a plurality of R¹ or R², these R¹ or R² may be identical with or different from each other.

Specifically, the metal alkoxide may be tetraethoxysilane [Si(OC₂H₅)₄], triisopropoxyaluminum [Al(O-2'-C₃H₇)₃], or the like. Tetraethoxysilane or triisopropoxyaluminum is preferred to be used because, after being hydrolyzed, they are relatively stable in an aqueous solvent.

The silane coupling agent may be a compound expressed by the following General Formula (II).

Si(OR¹¹)ₚ(R¹²)₃₋ₚR¹³ ... (II)

In General Formula (II), R¹¹ represents an alkyl group such as a methyl group, R¹² represents an alkyl group substituted with an alkyl group, aralkyl group, aryl group, alkenyl group, or acryloxy group, or a monovalent organic group such as an alkyl group substituted with a methacryloxy group, R¹³ represents a monovalent organic functional group, and p represents an integer from 1 to 3. If there are a plurality of R¹¹ or R¹², these R¹¹ or R¹² may be identical with or different from each other. The monovalent organic functional group represented by R¹³ may be a glycidyloxy group, epoxy group, mercapto group, hydroxyl group, amino group, halogen-substituted alkyl group, or monovalent functional group containing an isocyanate group.

Specifically, the silane coupling agent may be vinyltrimethoxysilane, γ-chloropropylmethyldimethoxysilane, γ-chloropropyltrimethoxysilane, glycidoxypropyltrimethoxysilane, γ-methacryloxypropyltrimethoxysilane, γ-methacryloxypropylmethyldimethoxysilane, or the like.

The silane coupling agent may be a multimer polymerized by the compound expressed by General Formula (II). The multimer is preferred to be a trimer, and more preferred to be 1,3,5-tris(3-trialkoxysilylalkyl) isocyanurate. This is a condensation polymer of a 3-isocyanatoalkyl alkoxysilane. It is known that this 1,3,5-tris(3-trialkoxysilylalkyl) isocyanurate has no chemical reactivity in the isocyanate moiety but secures reactivity due to the polarity of the nurate moiety. Generally, it is known that this 1,3,5-tris(3-trialkoxysilylalkyl) isocyanurate is added to an adhesive or the like, similarly to 3-isocyanatoalkyl alkoxysilane, to serve as an adhesion improver. Therefore, by adding 1,3,5-tris(3-trialkoxysilylalkyl) isocyanurate to a hydroxyl group-containing polymer compound, water resistance of the gas barrier coating layer can be improved due to hydrogen bonding. While 3-isocyanatoalkyl alkoxysilane has high reactivity and low liquid stability, 1,3,5-tris(3-trialkoxysilylalkyl) isocyanurate is easily dispersed in an aqueous solution and stably maintains viscosity, although the nurate moiety is not water soluble due to its polarity. The water resistance performance of 3-isocyanatoalkyl alkoxysilane is equivalent to that of 1,3,5-tris(3-trialkoxysilylalkyl) isocyanurate.

The 1,3,5-tris(3-trialkoxysilylalkyl) isocyanurate is produced using thermal condensation of 3-isocyanatopropyl alkoxysilane as a base material and may contain the base material; however, this poses no particular issue for the function as an agent. The 1,3,5-tris(3-trialkoxysilylalkyl) isocyanurate is more preferred to be 1,3,5-tris(3-trialkoxysilylpropyl) isocyanurate, and even more preferred to be 1,3,5-tris(3-trimethoxysilylpropyl) isocyanurate. The 1,3,5-tris(3-trimethoxysilylpropyl) isocyanurate is practically advantageous in practice because this methoxy group has a fast hydrolysis rate, and those agents which contain propyl groups are relatively cheaply available.

The amount of the metal alkoxide in the overcoating agent is preferred to be 1 to 4 parts by mass, or more preferred to be 2 to 3 parts by mass, with respect to 1 part by mass of the hydroxyl group-containing polymer compound, from the perspective of fragrance permeation-inhibiting properties, adhesion to the inorganic deposition layer, and maintaining gas barrier properties. Similarly, the amount of the silane coupling agent is preferred to be 0.01 to 1 parts by mass, or more preferred to be 0.1 to 0.5 parts by mass, with respect to 1 part by mass of the hydroxyl group-containing polymer compound. If a silane compound (alkoxysilane) is used as the metal alkoxide, the amount of the silane compound (the metal alkoxide and the silane coupling agent) in the overcoating agent is preferred to be 1 to 4 parts by mass, or more preferred to be 2 to 3 parts by mass, with respect to 1 part by mass of the hydroxyl group-containing polymer compound.

The overcoating agent may contain, as necessary, isocyanate compounds, or known additives such as dispersants, stabilizers, viscosity modifiers, and coloring agents as long as the gas barrier properties are not impaired.

### (Second mode of gas barrier coating layer)

The gas barrier coating layer may contain a polycarboxylic acid polymer crosslinked with polyvalent metal or a polyvalent metal compound. Such a gas barrier coating layer may be formed using a composition containing a polycarboxylic acid polymer and a composition containing polyvalent metal or a polyvalent metal compound and heating and drying them, or may be formed by heating and drying a composition containing a polycarboxylic acid polymer and polyvalent metal or a polyvalent metal compound.

For the polycarboxylic acid polymer, an existing polycarboxylic acid polymer can be used. The "existing polycarboxylic acid polymer" is a general term for polymers having two or more carboxy groups in the molecule. Specifically, homopolymers using α,β-monoethylenically unsaturated carboxylic acids, copolymers of at least two types of α,β-monoethylenically unsaturated carboxylic acids each composed of only an α,β-monoethylenically unsaturated carboxylic acid, copolymers of an α,β-monoethylenically unsaturated carboxylic acid and other ethylenically unsaturated monomers, and acidic polysaccharides having carboxy groups in the molecules, such as alginic acid, carboxymethyl cellulose, and pectin can be exemplified as polymeric monomers. These polycarboxylic acid polymers can be used singly or in combination of two or more.

The α,β-monoethylenically unsaturated carboxylic acids may typically be acrylic acid, methacrylic acid, itaconic acid, maleic acid, fumaric acid, crotonic acid, and the like. Ethylenically unsaturated monomers copolymerizable with them may typically be saturated carboxylic acid vinyl esters such as ethylene, propylene, and vinyl acetate, alkyl acrylates, alkyl methacrylates, alkyl itaconates, acrylonitrile, vinyl chloride, vinylidene chloride, vinyl fluoride, vinylidene fluoride, styrene, and the like. If the polycarboxylic acid polymer is a copolymer of an α,β-monoethylenically unsaturated carboxylic acid and a saturated carboxylic acid vinyl ester such as vinyl acetate, this copolymer can be used after being further saponified to convert the saturated carboxylic acid vinyl ester portions into vinyl alcohol. If the polycarboxylic acid polymer is a copolymer of an α,β-monoethylenically unsaturated carboxylic acid and any other ethylenically unsaturated monomers, the copolymer composition is preferred to contain an α,β-monoethylenically unsaturated carboxylic acid monomer composition of 60 mol% or more, from the perspective of gas barrier properties and heat resistance of the film obtained. The content of the composition is more preferred to be 80 mol% or more, even more preferred to be 90 mol% or more, and most preferred to be 100 mol%. In other words, the polycarboxylic acid polymer is preferred to be a polymer composed of only α,β-monoethylenically unsaturated carboxylic acids. If the polycarboxylic acid polymer is a polymer composed of only α,β-monoethylenically unsaturated carboxylic acids, specific preferred examples thereof may include polymers obtained by polymerizing at least one type of polymerizable monomers selected from the group consisting of acrylic acid, methacrylic acid, itaconic acid, maleic acid, fumaric acid, and crotonic acid, and mixtures of these polymers. Preferably, polymers obtained by polymerizing at least one polymerizable monomer selected from acrylic acid, methacrylic acid, and maleic acid, copolymers thereof and/or mixtures of the polymers and copolymers can be used. More preferably, polyacrylic acids, polymethacrylic acids, and polymaleic acids, and mixtures thereof can be used. If the polycarboxylic polymer is a compound other than the polymers of α,β-monoethylenically unsaturated carboxylic acid monomers, e.g., if it is an acidic polysaccharide, alginic acid is preferred to be used.

From the perspective of film formability, the number average molecular weight of the polycarboxylic acid polymer is preferred to be in the range of 2,000 to 10,000,000, and more preferred to be 5,000 to 1,000,000, although it is not particularly limited thereto.

As the material for forming the gas barrier coating layer, materials mixed with other polymers can be used other than the polycarboxylic acid polymers, as long as the fragrance permeation-inhibiting properties, gas barrier properties, and heat resistance of the gas barrier coating layer are not impaired; however, it is preferred to use a polycarboxylic acid polymer alone.

Polyvalent metals refer to polyvalent metal atomic units with metal ion valence of 2 or more, and polyvalent metal compounds refer to compounds thereof. Specific examples of the polyvalent metals include alkaline earth metals such as beryllium, magnesium, and calcium; transition metals such as titanium, zirconium, chromium, manganese, iron, cobalt, nickel, copper, and zinc; and aluminum. Specific examples of the polyvalent metal compounds include oxides, hydroxides, carbonates, organic acid salts, inorganic acid salts of the polyvalent metals, ammonium complexes of polyvalent metals, secondary to quaternary amine complexes of polyvalent metals, and carbonates or organic acid salts of these complexes. The organic acid salts include acetates, oxalates, citrates, lactates, phosphates, phosphites, hypophosphites, stearates, and monoethylenically unsaturated carboxylates. The inorganic acid salts include chlorides, sulfates, and nitrates. Other than these materials, alkylalkoxides of polyvalent metals and the like can be mentioned.

These polyvalent metals or polyvalent metal compounds can be used singly or as a mixture of two or more. Of these materials, divalent polyvalent metal compounds are preferably used from the perspective of fragrance permeation-inhibiting properties, gas barrier properties, and heat resistance of the gas barrier coating layer. More preferably, alkaline earth metals and oxides, hydroxides and carbonates of cobalt, nickel, copper and zinc, as well as ammonium complexes of cobalt, nickel, copper and zinc, and carbonates of these complexes can be used. Most preferably, oxides, hydroxides, carbonates of magnesium, calcium, copper and zinc, ammonium complexes of copper or zinc, and carbonates of these complexes can be used.

As long as the fragrance permeation-inhibiting properties, gas barrier properties, and heat resistance of the gas barrier coating layer is not impaired, a metal compound of monovalent metal, e.g., monovalent metal salt of a polycarboxylic acid polymer, can be used. A preferred amount of the monovalent metal compound added is 0.2 chemical equivalents or less with respect to the carboxy group of the polycarboxylic acid polymer, from the perspective of fragrance permeation-inhibiting properties, gas barrier properties, and heat resistance of the gas barrier coating layer. The monovalent metal compound may be partially contained in the molecules of the polyvalent metal salt of the polycarboxylic acid polymer.

The form of the polyvalent metal and the polyvalent metal compound is not particularly limited. However, in the gas barrier coating layer, part or all of the polyvalent metal and polyvalent metal compound forms a salt with the carboxy group of the polycarboxylic acid polymer. Accordingly, if the gas barrier coating layer contains a polyvalent metal or polyvalent metal compound that is not related to carboxylic salt formation, or if the gas barrier coating layer is a layer structure unit in which a layer containing a polycarboxylic acid polymer and a layer containing a polyvalent metal or polyvalent metal compound are adjacent to each other, the polyvalent metal or polyvalent metal compound is preferred to be in the form of a powder and the particle size is preferred to be smaller, from the perspective of transparency of the gas barrier coating layer. Furthermore, from the perspective of efficiently preparing an overcoating agent for producing a film, or obtaining a more uniform overcoating agent, the polyvalent metal or polyvalent metal compound is preferred to be in the form of a powder and the particle size is preferred to be smaller. The polyvalent metal or polyvalent metal compound is preferred to have an average particle size of 5 µm or less, more preferably 1 µm or less, and most preferably 0.1 µm or less.

Regarding the amount of the polyvalent metal and polyvalent metal compound with respect to the polycarboxylic acid polymer in the gas barrier coating layer from the perspective of fragrance permeation-inhibiting properties, gas barrier properties, and heat resistance of the gas barrier coating layer, if the gas barrier coating layer includes at least one layer structure unit in which a layer containing a polycarboxylic acid polymer and a layer containing a polyvalent metal or polyvalent metal compound are adjacent to each other, the total of the polyvalent metal and polyvalent metal compound with respect to the total carboxy groups contained in the layers is preferred to be 0.2 chemical equivalents or more, i.e., the total chemical equivalent weight of the polyvalent metal and polyvalent metal compound with respect to the total carboxy groups contained in the layers is preferred to be 0.2 or more, based on all the layers adjacent to each other or the total number of the layers. The gas barrier coating layer, if it contains a mixture of a polycarboxylic acid polymer and a polyvalent metal or polyvalent metal compound, is preferred to contain the polyvalent metal or polyvalent metal compound in an amount of 0.2 chemical equivalents or more with respect to all the carboxy groups of the polycarboxylic acid polymer. For both of the gas barrier coating layers mentioned above, the amount of the polyvalent metal and polyvalent metal compound is more preferred to be 0.5 chemical equivalents or more and, from the perspective of formability or transparency of the gas barrier coating layer in addition to the above perspective, the amount is even more preferred to be in the range of 0.8 chemical equivalents or more and 10 chemical equivalents or less, and most preferred to be in the range of 1 chemical equivalent or more and 5 chemical equivalent or less.

The gas barrier coating layer with a structure of polycarboxylic acid polymer / polyvalent metal or polyvalent metal compound may contain a silicon-containing compound. The silicon-containing compound is at least one selected from the group consisting of silane coupling agents expressed by the following General Formula (1), hydrolysates of these agents, and condensates of these hydrolysates. Thus, even with a small amount, adhesion to the inorganic deposition layer can be improved, and heat resistance, water resistance, and the like can also be improved.

R¹Si(OR²)₃ ··· (1)

In General Formula (1), R¹ represents an organic group including a glycidyloxy group or amino group, R² represents an alkyl group, and the three R² may be the same or may be different from each other. It should be noted that in General Formula (1), the organic group of R¹ may be, for example, a glycidyloxyalkyl group, aminoalkyl group, or the like. The alkyl group of R² is preferred to be an alkyl group having 1 to 6 carbon atoms, and is particularly preferred to be a methyl group or ethyl group.

Specific examples of the silane coupling agent include γ-glycidoxypropyltrimethoxysilane, γ-glycidoxypropyltriethoxysilane, γ-aminopropyltrimethoxysilane, and γ-aminopropyltriethoxysilane. Of these materials, γ-glycidoxypropyltrimethoxysilane and γ-aminopropyltrimethoxysilane are particularly preferred.

The silicon-containing compound may be a silane coupling agent, or may be hydrolysates of the silane coupling agent, or may be condensates of the hydrolysates.

The hydrolysates include those in which at least one of the three OR² in General Formula (1) is OH. The condensates include those in which at least two molecules of hydrolysate Si-OH are condensed to form Si-O-Si bonds. It should be noted that the condensates of the hydrolysates of the silane coupling agent may be referred to as hydrolysis condensates.

Materials obtained by hydrolysis and condensation reaction of a silane coupling agent using a sol-gel method, for example, can be used. Usually, in silane coupling agents, hydrolysis easily occurs and condensation reaction easily occurs in the presence of acid or alkali, and therefore, silane coupling agents alone, hydrolysates alone of the agents, or condensates alone of these hydrolysates are rarely present. In other words, usually, silane coupling agents, hydrolysates of the agents, and condensates of the hydrolysates are present being mixed together. Hydrolysates may include partial hydrolysates and complete hydrolysates.

For example, the overcoating agent can be applied using dipping, roll coating, gravure coating, reverse gravure coating, air knife coating, comma coating, die coating, screen printing, spray coating, gravure offset printing, or the like, The coating obtained by applying an overcoating agent can be dried using, for example, a hot air drying method, hot roll drying method, high frequency irradiation method, infrared irradiation method, UV irradiation method, or a combination thereof.

The temperature for drying the coating is preferred to be, for example, 50 to 150°C, and is more preferred to be 70 to 100°C. If the drying temperature is in the above range, the occurrence of cracking can be further suppressed in the inorganic deposition layer or the gas barrier coating layer to develop good barrier properties.

The gas barrier coating layer may be formed using an overcoating agent that contains a hydroxyl group-containing polymer compound (e.g., polyvinyl alcohol resin) and a silane compound. As necessary, the overcoating agent may additionally contain an acid catalyst, alkaline catalyst, photoinitiator, and the like.

The silane compound may be a silane coupling agent, polysilazane, or siloxane, and may specifically be tetramethoxysilane, tetraethoxysilane, glycidoxypropyltrimethoxysilane, acryloxypropyltrimethoxysilane, hexamethyldisilazane, or the like.

The gas barrier coating layer is preferred to have a thickness of 50 nm to 1,000 nm, and more preferably 100 nm to 500 nm. If the thickness of the gas barrier coating layer is 50 nm or more, more sufficient gas barrier properties are likely to be obtained, and if it is 1,000 nm or less, sufficient flexibility is likely to be maintained.

### (Third mode of gas barrier coating layer)

The gas barrier coating layer may be a layer having an adhesive function. Such a layer can be referred to as an adhesive gas barrier coating layer. The adhesive gas barrier coating layer may be a cured product of an adhesive composition containing a resin having at least either of aromatic rings and aliphatic rings. In the cured product (cured film), parallel cyclic structures of aromatic rings or aliphatic rings are present to easily inhibit fragrance permeation.

The cured product is preferred to have a glass-transition temperature of 40°C or more and 70°C or less. If the glass-transition temperature is lower than 40°C, the effect of inhibiting fragrance permeation cannot be achieved, and if it exceeds 70°C, flexibility at around room temperature may become weak and adhesion to the adjacent layer may be deteriorated and therefore adhesion force may be reduced. As an adhesive satisfying these conditions, a two-component curing type adhesive comprising an epoxy resin and an amine epoxy resin curing agent can be exemplified The epoxy resin that can be used may be any of an alicyclic compound, aromatic compound, and monocyclic compound. Specifically, the epoxy resin may preferably be at least one resin selected from an epoxy resin having a glycidylamino group derived from meta-xylylenediamine, epoxy resin having a glycidylamino group derived from 1,3-bis(aminomethyl)cyclohexane, epoxy resin having a glycidylamino group derived from diaminodiphenylmethane, epoxy resin having a glycidylamino group and/or glycidyloxy group derived from para-aminophenol, epoxy resin having a glycidyloxy group derived from bisphenol A, epoxy resin having a glycidyloxy group derived from bisphenol F, epoxy resin having a glycidyloxy group derived from phenol novolak, and epoxy resin having a glycidyloxy group derived from resorcinol. Of these epoxy resins, the epoxy resin having a glycidylamino group derived from meta-xylylenediamine is particularly preferred.

The adhesive composition that can be exemplified may be an adhesive having two or more hydroxyl groups in one molecule as a functional group, and containing a polyester or polyester polyurethane resin obtained using an ortho-oriented aromatic dicarboxylic acid or its anhydride, as a polyvalent carboxylic acid of a monomer component of polyester, and a polyisocyanate containing at least one of diphenylmethane diisocyanate, polymeric diphenylmethane diisocyanate, and derivatives thereof.

As a specific example of a gas barrier adhesive, MAXIVE manufactured by Mitsubishi Gas Chemical Company, Inc., Paslim manufactured by DIC Corporation, or the like can be mentioned.

The adhesive gas barrier coating layer is preferred to have an oxygen permeability of 150 cc/m²·day·atm or less, more preferably 100 cc/m²·day·atm or less, even more preferably 80 cc/m²··day·atm or less, and most preferably 50 cc/m²·day·atm or less. If the oxygen permeability is in the above range, gas barrier properties can be improved more easily.

The adhesive gas barrier coating layer may have a thickness which is 50 times or more the thickness of the inorganic deposition layer. If the thickness is in the above range, cushioning to absorb external impact can be imparted to the gas barrier coating layer, cracking of the inorganic deposition layer can be suppressed more easily, the fragrance components can be prevented from dispersing into the first polyolefin layer, and higher levels of gas barrier and other properties can be achieved. From the perspective of maintaining flexibility, processability and cost of the packaging material, the thickness of the adhesive gas barrier coating layer may be 300 times or less the thickness of the inorganic deposition layer. The thickness of the adhesive gas barrier coating layer is preferred to be, for example 0.1 µm to 20 µm, more preferred to be 0.5 µm to 10 µm, and even more preferred to be 1 µm to 5 µm.

For example, the material (gas barrier adhesive) for forming the adhesive gas barrier coating layer can be applied using overcoating, dipping, roll coating, gravure coating, reverse coating, air knife coating, comma coating, die coating, screen printing, spray coating, gravure offset printing, or the like. The temperature for drying the coating is preferred to be, for example, 30 to 200°C, and more preferred to be 50 to 180°C. The temperature for curing the coating is preferred to be, for example, room temperature to 70°C, and more preferred to be 30 to 60°C. If the drying and curing temperatures are in the above ranges, the occurrence of cracking can be further suppressed in the inorganic deposition layer or the adhesive gas barrier coating layer, the fragrance components can be prevented from dispersing into the first polyolefin layer, and higher levels of gas barrier and other properties can be achieved.

The adhesive gas barrier coating layer can be directly formed on the inorganic deposition layer; however, from the perspective of protecting the inorganic deposition layer, other layers, such as a printed layer and gas barrier coating layer (having no adhesiveness), may be interposed between the two layers.

### (Printed layer)

A printed layer may be provided to the inorganic deposition layer-side surface of the first polyolefin layer, that is, the surface of the first polyolefin layer facing away from the surface provided with the inorganic deposition layer, or on the inorganic deposition layer, or other surfaces. The printed layer is placed at a position where it can be seen from outside the laminate, for the purpose of displaying information related to the contents, identifying the contents, or improving aesthetic factors of the packaging bag. The method of printing the printed layer and the printing ink used are not particularly limited, but can be appropriately selected from known printing methods and printing inks, considering printing suitability for the films and aesthetic factors such as color hue, as well as adhesion, safety as food containers, and other factors. Examples of the printing method may include gravure printing, offset printing, gravure offset printing, flexographic printing, and inkjet printing. Of these methods, gravure printing is preferably used from the perspective of productivity and high definition of pictorial patterns.

### (Second polyolefin layer)

The second polyolefin layer is formed of a material having a melting point lower than that of the material forming the first polyolefin layer, and having heat-sealing properties. Accordingly, the second polyolefin layer can be referred to as a sealant layer.

The materials forming the first and second polyolefin layers may be different from each other, but from the perspective of ease of reshaping of the resin material after being melted, these layers are preferred to be formed of the same material. The expression "formed of the same material" refers to, for example, the both layers being formed of polyethylenes or polypropylenes.

If the first polyolefin layer is made of a polyethylene, a linear low density polyethylene (LLDPE) can be used as the second polyolefin layer. For the purpose of imparting rigidity, a coextruded laminate film in which a high density polyethylene (HDPE) or medium density polyethylene (MDPE) forms the inorganic deposition layer side, and a low density polyethylene (LDPE) forms the heat-sealing side can be used as the second polyolefin layer.

If the first polyolefin layer is made of a polypropylene, the second polyolefin layer can be formed using an ethylene resin such as a low density polyethylene resin (LDPE), medium density polyethylene resin (MDPE), linear low density polyethylene resin (LLDPE), ethylene-vinyl acetate copolymer (EVA), ethylene-α-olefin copolymer, or ethylene-(meth)acrylic acid resin copolymer, a blend resin of polyethylene and polybutene, a polypropylene resin such as a homopolypropylene resin (PP), propylene-ethylene random copolymer, propylene-ethylene block copolymer, or propylene-α-olefin copolymer, or other resins.

The polyolefin film forming the second polyolefin layer may be formulated with various types of additives such as flame retardants, slip agents, anti-blocking agents, antioxidants, light stabilizers, and tackifiers.

The thickness of the second polyolefin layer is determined based on the amount of the contents, shape of the packaging bag, and other factors, but is preferred to be substantially 30 µm to 150 µm.

As a method of laminating the first polyolefin layer on which the inorganic deposition layer and the gas barrier coating layer are formed, with the second polyolefin layer having heat-sealing properties, any known lamination method can be used, such as a dry lamination method in which layers are bonded together using a one- or two-component curing type urethane adhesive, etc., a non-solvent dry lamination method in which layers are bonded together using a non-solvent adhesive, and an extrusion lamination method in which a polyolefin resin such as a polyethylene or polypropylene is heated and melted, and extruded into a curtain shape, followed by bonding. From the perspective of environmental friendliness, the adhesive used may be an adhesive containing polymer components derived from biomass or having biodegradability.

If an adhesive gas barrier coating layer is used, the first polyolefin layer on which the inorganic deposition layer is formed can be laminated with the second polyolefin layer having heat-sealing properties via the adhesive gas barrier coating layer.

As described above, the films forming the packaging material can all be polyolefin films. Such a packaging material can be referred to as a material formed of a single material (mono-material) having high recyclability. From this perspective, the total mass of the components other than polyolefins (e.g., components of the adhesion layer, metal deposition layer, gas barrier coating layer, adherent layer, etc.) is preferred to be 10 mass% or less, more preferred to be 7.5 mass% or less, and even more preferred to be 5.0 mass% or less, with respect to the total mass of the packaging material.

The packaging material may include another resin layer as a substrate, other than the first polyolefin layer. Another resin layer may be a polyolefin layer. As another resin layer, a film such as a film having high heat resistance, a uniaxially stretched film or the like with easy tearability, or a film including a coextruded nylon layer for impartment of puncture resistance, can be selected according to the purpose.

### <Packaging bag and packaging body>

A packaging bag can be obtained by heat-sealing surfaces of the second polyolefin layer of the packaging material obtained as described above. A packaging body can be obtained by filling esters or terpenes as fragrance materials in the packaging bag obtained as mentioned above, and sealing the bag.

### Examples

The present disclosure will be described more specifically with experimental examples; however, the present invention should not be limited to these experimental examples.

### (Preparation of Anchor coating agent)

An acrylic polyol and tolylene diisocyanate were mixed together so that the number of OH groups of the acrylic polyol was equivalent to the number of NCO groups of the tolylene diisocyanate, and the mixture was diluted with ethyl acetate so that the total solid content (total mass of the acrylic polyol and tolylene diisocyanate) was 5 mass%. β-(3,4-epoxycyclohexyl)ethyltrimethoxysilane was further added to and mixed with the diluted mixture so that the content thereof was 5 mass% with respect to the total mass, i.e., 100 mass%, of the acrylic polyol and tolylene diisocyanate, thereby preparing an anchor coating agent.

### (Preparation of overcoating agent (1))

The following Liquid A, Liquid B, and Liquid C were mixed at a ratio of 70/20/10 to prepare an overcoating agent (1).

Liquid A: Hydrolysis solution with a solid (calculated as SiO₂) content of 5 mass% obtained by adding 72.1 g of 0.1N hydrochloric acid to 17.9 g of tetraethoxysilane (Si(OC₂H₅)₄) and 10 g of methanol, and stirring the mixture for 30 minutes for hydrolysis

Liquid B: Water/methanol solution (mass ratio of water: methanol was 95:5) with a polyvinyl alcohol content of 5 mass%

Liquid C: Hydrolysis of 1,3,5-tris(3-trimethoxysilylpropyl) isocyanurate diluted with a water/isopropyl alcohol mixture (mass ratio of water: isopropyl alcohol was 1:1) so that the solid content was 5 mass%

### (Preparation of overcoating agent (2))

An overcoating agent (2-1) was prepared by preparing a polyacrylic acid solution by adding 200 g of water to 50 g of Aron A-10H as a polyacrylic acid (number average molecular weight: 200,000) manufactured by Toagosei Co., Ltd., and by adding thereto 1.5 g of zinc oxide fine particle aqueous dispersion manufactured by FUJIFILM Wako Pure Chemical Corporation, followed by stirring the mixture at room temperature for 2 days.

An overcoating agent (2-2) was prepared by mixing 100 g of ZE143 as a zinc oxide fine particle aqueous dispersion manufactured by Sumitomo Osaka Cement Co.,Ltd. with 1 g of Liofol HAERTER UR 5889-21 as a curing agent manufactured by Henkel AG & Co. KGaA.

### (Preparation of overcoating agent (3))

A polyacrylic acid solution was prepared by adding 10 g of JURYMER AC-10LP (number average molecular weight: 50,000) as a polyacrylic acid manufactured by Toagosei Co., Ltd. to 100 g of isopropyl alcohol.

A zinc oxide dispersion was prepared by dispersing 100 g of FINEX-30 as zinc oxide manufactured by Sakai Chemical Industry Co., Ltd. and 15 g of DA-325 as a surfactant manufactured by Kusumoto Chemicals, Ltd. into 220 g of isopropyl alcohol.

An overcoating agent (3) was prepared by mixing 80 parts by mass of the acrylic acid solution with 20 parts by mass of the zinc oxide dispersion.

### (Preparation of overcoating agent (4))

An overcoating agent (4) was prepared by mixing Liquid A, Liquid B, and Liquid C of the overcoating agent (1) at a ratio of 40/50/10.

### (Preparation of overcoating agent (5))

An overcoating agent (5) was prepared by mixing 16 parts by mass of MAXIVE C93T and 5 parts by mass of MAXIVE M-100 both manufactured by Mitsubishi Gas Chemical Company, Inc. with 23 parts by mass of solvent containing ethyl acetate and methanol at a mass ratio of 1:1.

### (Preparation of adhesive)

A urethane adhesive was prepared by mixing 11 parts by mass of TAKENATE A52 manufactured by Mitsui Chemicals, Inc. and 84 parts by mass of ethyl acetate, with 100 parts by mass of TAKELAC A525 manufactured by Mitsui Chemicals, Inc.

### (Example 1)

The anchor coating agent was applied to a corona-treated surface of an unstretched high density polyethylene (HDPE) having a thickness of 32 µm using gravure coating, followed by drying to provide an anchor coat layer having a thickness of 0.1 µm.

A transparent inorganic deposition layer (aluminum deposited layer) of aluminum oxide having a thickness of 10 nm was formed using a vacuum deposition device using an electron beam heating method. The O/Al ratio of the aluminum deposited layer was 1.5.

The overcoating agent (1) was applied to the aluminum deposited layer using gravure coating, followed by drying to form an overcoat layer having a thickness of 0.3 µm.

A sealant film of a linear low density polyethylene (LLDPE) having a thickness of 40 µm was laminated on the overcoat layer using a dry lamination method using the urethane adhesive.

### (Example 2)

As an inorganic deposition layer, a transparent inorganic deposition layer (silica deposited layer) of silicon oxide having a thickness of 30 nm was formed using a vacuum deposition device using an electron beam heating method. The O/Si ratio of the silica deposited layer was 1.8. Except for these points, a laminate was obtained as in Example 1.

### (Example 3)

A laminate was obtained as in Example 2, except that a uniaxially stretched high density polyethylene (HDPE) having a thickness of 25 µm was used as a substrate.

### (Example 4)

A laminate was obtained as in Example 2, except that a stretched polypropylene (OPP) having a thickness of 20 µm was used as a substrate and an unstretched polypropylene (CPP) film having a thickness of 50 µm was used as a sealant film.

### (Example 5)

A polypropylene and EVOH with an interposition of an adhesive resin therebetween were coextruded and sequentially stretched to obtain a multilayer film as an anchor coat layer including 1-µm EVOH, on an 18-µm stretched polypropylene (OPP).

A transparent inorganic deposition layer (silica deposited layer) of silicon oxide having a thickness of 30 nm was formed on the EVOH surface using a vacuum deposition device based on electron beam heating method. The O/Si ratio of the silica deposited layer was 1.8.

The overcoating agent (1) was applied to the silica deposited layer using gravure coating, followed by drying to form an overcoat layer having a thickness of 0.3 µm.

A sealant film having a thickness of 50 µm made of an unstretched polypropylene (CPP) was laminated on the overcoat layer using a dry lamination method using the urethane adhesive.

### (Example 6)

The overcoating agent (5) was applied to a silica deposited layer using a dry lamination method, followed by drying to form an adhesive gas barrier coating layer having a thickness of 2.5 µm. A sealant film of a linear low density polyethylene (LLDPE) having a thickness of 40 µm was laminated via the adhesive gas barrier coating layer. Except for these points, a laminate was obtained as in Example 2.

### (Example 7)

The overcoating agent (5) was applied to a silica deposited layer using a dry lamination method, followed by drying to form an adhesive gas barrier coating layer having a thickness of 2.5 µm. An unstretched polypropylene (CPP) having a thickness of 50 µm was laminated via the adhesive gas barrier coating layer. Except for these points, a laminate was obtained as in Example 4.

### (Example 8)

A laminate was obtained as in Example 1 except that a stretched polypropylene (OPP) having a thickness of 20 µm was used as a substrate, the overcoating agents (2-1) and (2-1) were sequentially applied using gravure coating, followed by drying to form an overcoat layer (containing polyacrylic acid crosslinked with zinc oxide) having a thickness of 0.6 µm, and an unstretched polypropylene (CPP) film having a thickness of 50 µm was used as a sealant film.

### (Example 9)

A laminate was obtained as in Example 8 except that the overcoating agent (3) was applied using gravure coating, followed by drying to form an overcoat layer having a thickness of 0.4 µm.

### (Example 10)

A laminate was obtained as in Example 4 except that the overcoating agent (4) was applied using gravure coating, followed by drying to form an overcoat layer having a thickness of 0.4 µm.

### (Comparative Example 1)

A laminate was obtained as in Example 1 except that no overcoat layer was provided.

### (Comparative Example 2)

A laminate was obtained as in Example 2 except that no overcoat layer was provided.

### (Comparative Example 3)

A laminate was obtained as in Example 1 except that none of the anchor coat layer, inorganic deposition layer, and overcoat layer were provided.

### (Comparative Example 4)

A laminate was obtained as in Example 4 except that none of the anchor coat layer, inorganic deposition layer, and overcoat layer were provided.

### (Comparative Example 5)

A laminate was obtained as in Example 5 except that neither the inorganic deposition layer nor the overcoat layer was provided.

### (Comparative Example 6)

A laminate was obtained by laminating a sealant film of a linear low density polyethylene (LLDPE) having a thickness of 40 µm on the corona-treated surface of polyethylene terephthalate (PET) having a thickness of 12 µm using a dry lamination method using a urethane adhesive.

### [Method of measuring oxygen permeability]

Oxygen permeability (OTR) of the laminates obtained in the examples was measured using an oxygen permeability measuring device (product name: OX-TRAN2/20 manufactured by Modern Controls, Inc.) under the conditions of 30°C and 70%RH. Oxygen permeability of the laminates other than Comparative Examples 3 to 5 was measured based on JIS K-7126, method B (equal-pressure method). Oxygen permeability of Comparative Examples 3 to 5 was measured based on a differential-pressure method using an oxygen permeability measuring device (product name: GTR-3000 manufactured by GTR Tec Corporation). The results are shown in Table 1.

### [Method of measuring water vapor permeability]

Water vapor permeability (WTR) of the laminates obtained in the examples was measured using a water vapor permeability measuring device (product name: PERMATRAN-W 3/33 manufactured by Modern Controls, Inc.) under the conditions of 40°C and 90%RH. Water vapor permeability was measured based on JIS K 7126, method B (equal-pressure method). The results are shown in Table 1.

**[Table 1]**

| | Barrier properties | |
|---|---|---|
| | OTR (cc/m²·day·MPa) | WTR (g/m²·day) |
| Ex. 1 | 3.1 | 0.9 |
| Ex. 2 | 1.5 | 0.7 |
| Ex. 3 | 5.4 | 0.9 |
| Ex. 4 | 0.9 | 0.9 |
| Ex. 5 | 0.6 | 1.2 |
| Ex. 6 | 0.8 | 0.7 |
| Ex. 7 | 0.4 | 0.6 |
| Ex. 8 | 0.6 | 1.1 |
| Ex. 9 | 0.5 | 0.9 |
| Ex. 10 | 0.3 | 1.1 |
| Comp. Ex. 1 | 12 | 0.9 |
| Comp. Ex. 2 | 6.1 | 0.7 |
| Comp. Ex. 3 | 1513 | 1.8 |
| Comp. Ex. 4 | 1665 | 2.6 |
| Comp. Ex. 5 | 144 | 2.7 |
| Comp. Ex. 6 | 125.6 | 5.8 |

### [Evaluation of fragrance components permeation-inhibiting properties]

### (Sensory evaluation)

100 mm × 100 mm square samples were cut out from the laminate of each example, two samples were overlapped with each other so that the sealant films face each other, and 3 sides of the overlapped samples were impulse-sealed into a pouch to obtain a packaging bag.

The obtained packaging bags were each filled with 10 g of shampoo which was "Lux super rich shine damage repair shampoo" manufactured by Unilever plc (containing esters such as ethyl methylbutyrate, ethyl 2-methylvalerate, hexyl acetate, allyl hexanoate, allyl heptanoate, and benzyl acetate, and terpenes such as limonene, as fragrance components), or 10 g of fabric softener which was "Lenor HAPPINESS antique rose & floral fragrance" manufactured by Procter & Gamble (containing esters such as ethyl methylbutyrate, ethyl 2-methylbutyrate, isoamyl acetate, ethyl 2-methylvalerate, hexyl acetate, allyl hexanoate, allyl heptanoate, α-methylbenzyl acetate, benzyl acetate, β-pinene, allyl cyclohexanepropionate, 2-phenoxyethyl isobutyrate, and terpenes such as limonene, α-terpineol, β-citronellol, and myrcene, as fragrance components), and sealed. The sealing width was 5 mm (with an internal surface area of 9 cm × 9 cm). Thus, packaging bodies provided with packaging bags and contents containing fragrances packaged in the packaging bags were obtained.

The obtained packaging bodies were each sealed in an aluminum bag formed of PET / aluminum foil / LLDPE together with 140 cc of air and left to stand at 40°C for 10 days.

After being left to stand, part of each aluminum bag was opened and smelled to conduct a sensory evaluation based on the following evaluation criteria. The results are shown in Table 3.
---: Smell of the fragrance components was not perceived at al.
--: Smell of the fragrance components was hardly perceived.
-: Smell of the fragrance components was only weakly perceived.
+: Smell of the fragrance components was perceived.
++: Smell of the fragrance components was strongly perceived.
+++: Smell of the fragrance components was very strongly perceived.

### (Qualitative analysis of fragrance components)

Packaging bodies were obtained similarly to those for the sensory evaluation. The obtained packaging bodies were each sealed in an aluminum bag together with 140 cc of air and left to stand at 40°C for 10 days.

1 mL of gas was extracted with a gas-tight syringe from each aluminum bag that had been left to stand, to conduct a qualitative analysis of the components in the air and a qualitative analysis of the hexyl acetate, as an example, under the conditions shown in Table 2 using a GC/MS method. For the measurement, a gas chromatograph/mass spectrometer (Model No.: GC6890/MSD5973 manufactured by Agilent Technologies) was used. 0.01 g of the contents containing fragrances (the shampoo or the fabric softener) was placed in a 20-mL vial bottle, followed by heating at 60°C for 20 minutes. After that, gas in the gas phase was extracted with a gas-tight syringe and subjected to GC/MS to identify the fragrance components. The results are shown in Table 3. In Table 3, the fragrance component cut rates of Examples 1 to 3 and 6, and Comparative Examples 1 and 2 were each obtained by dividing the GC peak area of the example in question by the GC peak area of Comparative Example 3 (all were all-PE packaging materials, and the fragrance component cut rate of Comparative Example 3 was defined to be 0%). Similarly, fragrance component cut rates of Examples 4 and 7 to 10 were calculated based on Comparative Example 4 (all were all-PP packaging materials.), and that of Example 5 was calculated based on Comparative Example 5 (both were all-PP/EVOH packaging materials).

### (Quantitative analysis of hexyl acetate)

0.1 µL of hexyl acetate was dropped in a 140-mL mayonnaise jar and, with the lid closed, heated in an oven at 40°C for 30 minutes. After that, 1 mL of gas in the mayonnaise jar was extracted with a gas-tight syringe and subjected to GC/MS analysis, and a calibration curve was created using the peak areas in the obtained ion chromatogram extracted at m/z=56. Using the calibration curve, the amount of hexyl acetate was quantified from the peak area at m/z=56 obtained from GC/MS analysis for each example. The results are shown in Table 3.

For terpenes (limonene and citronellol can be focused on as examples), no quantitative analysis was conducted; however, the sum of peak areas in the qualitative analysis were significantly smaller in the examples than in the comparative example.

**[Table 3]**

| | Sensory evaluation | | Qualitative analysis | | | | Quantitative analysis | |
|---|---|---|---|---|---|---|---|---|
| | | | Shampoo | | Fabric softener | | Amount of hexyl acetate | |
| | Shampoo | Softener | Sum of GC peak areas | Perfume ingredient cut rate (%) | Sum of GC peak areas | Perfume ingredient cut rate (%) | Shampoo (µg) | Softener (µg) |
| Ex. 1 | -- | - | 16.025 | 98.5 | 323.235 | 91.6 | 0.6 | 1.8 |
| Ex. 2 | - | - | 13.565 | 98.7 | 244.695 | 93.7 | 0.4 | 1.5 |
| Ex. 3 | - | - | 15.172 | 98.6 | 261.163 | 93.2 | 0.7 | 2.1 |
| Ex. 4 | - | -- | 0 | 100 | 23.541 | 98.5 | - | 0.9 |
| Ex. 5 | --- | -- | 0 | 100 | 17.602 | 98.9 | - | 0.4 |
| Ex. 6 | - | - | 11.485 | 99 | 228.745 | 94.1 | 0.3 | 1.4 |
| Ex. 7 | --- | -- | 0 | 100 | 21.452 | 98.6 | - | 0.8 |
| Ex. 8 | --- | -- | 0 | 100 | 23.621 | 98.5 | - | 1.0 |
| Ex. 9 | --- | -- | 0 | 100 | 22.450 | 98.6 | - | 0.9 |
| Ex. 10 | --- | -- | 0 | 100 | 20.945 | 98.7 | - | 0.7 |
| Comp. Ex. 1 | - | + | 46.752 | 95.7 | 761.812 | 80.3 | 2.1 | 7.2 |
| Comp. Ex. 2 | - | + | 26.984 | 97.5 | 684.255 | 82.3 | 1.7 | 6.4 |
| Comp. Ex. 3 | ++ | +++ | 1,075.122 | PE base standard | 3,869.044 | PE base standard | 27.5 | 27.8 |
| Comp. Ex. 4 | + | + | 162.313 | PP base standard | 1,568.650 | OPP base standard | 5.8 | 12.1 |
| Comp. Ex. 5 | + | + | 148.888 | PP/EVOH base standard | 1,548.418 | PP/EVOH base standard | 5.2 | 11.5 |
| Comp. Ex. 6 | --- | --- | 0 | 100.0 | 0 | 100.0 | 0 | 0 |

### [Industrial Applicability]

The packaging material according to the present disclosure has excellent permeation-inhibiting properties for fragrance components, and can preferably package contents containing fragrances. Furthermore, the packaging material according to the present disclosure can contain polyolefins with an amount of 90 mass% or more with respect to the total mass of the packaging material and thus these materials can be recycled.

### [Reference Signs List]

- 1: First polyolefin layer
- 2: Inorganic deposition layer
- 3: Gas barrier coating layer
- 4: Second polyolefin layer
- 10: Packaging material

## Claims

1. A packaging material for packaging contents containing fragrances, comprising
a first polyolefin layer, an inorganic deposition layer, a gas barrier coating layer, and a second polyolefin layer having heat-sealing properties, in this order.

2. The packaging material according to claim 1, wherein the gas barrier coating layer is a heat-dried product of a composition containing at least one of a hydroxyl group-containing polymer compound and a hydrolysate thereof, and at least one material selected from a group consisting of metal alkoxides, silane coupling agents, and hydrolysates thereof.

3. The packaging material according to claim 1, wherein the gas barrier coating layer contains a polycarboxylic acid polymer crosslinked with polyvalent metal or a polyvalent metal compound.

4. The packaging material according to claim 1, wherein the gas barrier coating layer is a cured product of an adhesive composition containing a resin having at least either of aromatic rings and aliphatic rings.

5. The packaging material according to any one of claims 1 to 4, wherein the inorganic deposition layer contains at least one of aluminum oxide and silicon oxide.

6. The packaging material according to any one of claims 1 to 5, wherein the first polyolefin layer and the second polyolefin layer are made of the same material.

7. The packaging material according to any one of claims 1 to 6, wherein the first polyolefin layer and the second polyolefin layer are made of polyethylenes.

8. The packaging material according to any one of claims 1 to 6, wherein the first polyolefin layer and the second polypropylene layer are made of polypropylenes.

9. A packaging bag formed of the packaging material according to any one of claims 1 to 8.

10. A packaging body comprising the packaging bag according to claim 9 and contents containing fragrances packaged in the packaging bag.

11. The packaging body according to claim 10, wherein the fragrance materials contain at least either of esters and terpenes.
